# EUROPEAN PATENT APPLICATION

(11) **EP 4 429 418 A1**
(43) Date of publication of application: **11.09.2024**
(21) Application number: 23160708.6
(22) Date of filing: 08.03.2023
(51) Int. Cl.: H05K 3/34, H05K 1/02

(54) **CIRCUIT BOARD**

(71) Applicant: Magna Electronics Sweden AB, 447 37 Vårgårda (SE)
(72) Inventor: ROMBO, Lars, 583 30 Linköping (SE)
(74) Representative: Müller Verweyen

(57) **Abstract**

The invention relates to a circuit board (10) with at least one mounting position (11) for a surface mounted component (12), wherein the surface mounted component (12) is a bottom terminated component, wherein the mounting position (11) comprises a central solder pad (13). The circuit board (10) comprises at least one through-hole (14) in central solder pad (13), wherein the surface (15) of the at least one through-hole (14) is non-conductive.

## Description

The invention relates to a circuit board with at least one mounting position for a surface mounted component according to the preamble of claim 1.

Electronics comprise surface mounted components, such as integrated circuits, that are soldered to a circuit board. A circuit board can be, for example, a printed circuit board (PCB) that enables the connection of multiple electronic components, like surface mounted components (SMC), to be mounted to the circuit board. Typically, the electronic components are soldered to the circuit board. In modern electronics, bottom terminated components (BTC) are used, which comprise a large central solder joint that provides the mechanical strength and fixation between the electronic component and the circuit board, as well as a thermal connection to transfer heat away from the electronic component. The central solder pad of the circuit board is therefore also called thermal pad. This connection does not have a visible solder joint, so inspection often relies on x-ray scanning.

A common problem with BTC components, especially with bigger components, is voids in the large central solder joint, reducing the thermal transfer and mechanical strength of the solder joint. Voids are bubbles that form a space in the solder joint, which act as an insulator. These voids occur when the circuit board is heated for curing of the solder paste and can be a result of trapped residual gas in the solder paste or flux that turns to gas, builds up and is trapped during heating. The voids in the central joint on the thermal pad tend to lift the component body, and affect the small signal pads around the edges. The component may tilt, and the distances at the sides may vary. Solder is pulled under the component, when the component is higher. Therefore, the signal leads can become stretched. Furthermore, there is often no visible solder joint to inspect. This results in a potential quality issue, and makes the solder joint very hard to inspect in any automated inspection system. To address the issues of voids, specific requirements are set for the max percentage of void area. Accordingly, in order to provide a sufficient thermal connection and mechanical strength between the BTC components and the circuit board, the void content in the central solder joint must be below a certain limit and is checked by means of x-ray scanning.

From KR10-2009-0123385 it is known that residual air may escape through a plurality of thermal through vias to avoid void phenomena. However, these thermal through vias become clogged when solder melts and lose their venting function.

It is the object of the invention to provide an improved circuit board.

The invention solves this object with the features of the independent claims.

A circuit board with at least one mounting position for a surface mounted component is proposed, wherein the surface mounted component is a bottom terminated component, wherein the mounting position comprises a central solder pad, characterized in that the circuit board comprises at least one through-hole in the central solder pad, wherein the surface of the at least one through-hole is non-conductive.

The through-hole or through-holes in the central solder pad allow for flux that has become gaseous during the reflow process, or other gaseous components, to vent to the bottom or underside of the circuit board. Herein, non-conductive refers to non-conductive with respect to electricity. The proposed through-hole with a non-conductive surface can also be referred as ventilator via. The invention has recognized that the metal plated thermal through vias in the prior art attract the solder, and wetting and capillary forces will fill the vias with solder. As a result, the thermal vias in the prior art become clogged and lose their venting function early in the soldering process as the solder wetting creates a hermetic seal. According to the invention, the surface of the through-hole is non-conductive, thus the solder will not wet the surface of the through-hole. The non-conductive surface of the through-hole is preferably not wettable. Accordingly, the solder will not wick down the through-hole, leaving the through-hole open after the solder has melted. Gaseous flux can escape to the underside of the circuit board, but there is no solder wicking down the through-holes. This greatly improves gas venting from the melted solder compared to vias which clog early in the reflow process. As a result, the void content in a central solder joint at the central solder pad or thermal pad of the circuit board can be effectively reduced by having at least one through-hole. Accordingly, the bond quality and the process stability can be improved with the proposed design of a circuit board.

Additionally, venting to the underside of the circuit board through the through-holes also reduces the amount of flux transferred to the signal leads and reduces the risk for electromigration.

The circuit board may comprise multiple through-holes in the central solder pad, for example 3 or 4 through-holes.

It is further proposed that the surface of the at least one through-hole is glass fiber-reinforced plastic. Such a non-conductive surface can be created by means of drilling, wherein the circuit board is made of a glass fiber reinforced plastic, for example FR-4. The circuit board is preferably a printed circuit board (PCB). Thus, the surface of the through-hole is preferably created by the cutting the substrate material of the circuit board. The surface of the through-hole is not wetted by the solder and thus stays open and allows gases to be vented to the bottom of the circuit board.

In a preferred development, it is proposed that the at least one through-hole is unplated. The unplated through-hole is not wetted by solder during the reflow process. This avoids clogging of the through-hole with solder as soon as the reflow process starts. Thereby, venting is possible for a longer time and trapped gases and voids in the solder joint can be avoided.

Preferably, the central solder pad has a cutout in the copper layer around the at least one through-hole. This further reduces the possibility of solder to wick down the through-hole and clogging the through-hole.

It is further proposed that the at least one through-hole is arranged in a trench in the central solder pad. A trench in the solder pad allows the passage of gaseous components from the vicinity of the trench along the trench, wherein these gaseous components can be vented to the bottom side of the circuit board and away from a solder joint on the central solder pad and a surface mounted component.

Preferably, the trench is arranged in a diagonal of the central solder pad. The proposed solution directs any excess flux material away from the central solder pad or the central solder joint away from the multiple solder contacts respectively the leads connecting the bottom terminated component to the circuit board. Therefore, any contamination of the leads for input/output of a BTC component can be avoided.

It is further preferred that the trench extends into a corner of the central solder pad. Thereby, any excess flux material or gas from a central solder joint on the central solder pad is guided further away from the solder contacts or leads.

In an advantageous embodiment, four through-holes are arranged in a rectangular shape in the central solder pad.

In another preferred embodiment, three through-holes are arranged in a triangular shape in the central solder pad.

Preferably, the circuit board comprises at least one thermal vias besides the at least one through-hole. Thereby, the thermal vias can provide a thermal conductivity to conduct heat away from the bottom terminated components, while the through-hole provides venting during the soldering process. The thermal vias may be arranged in the central solder pad in a cross-shape, dividing the central solder pad into four rectangles. This is in particular advantageous with four through-holes arranged in rectangular shape, so that each of the four rectangles comprises a through-hole for the purpose of venting in the middle.

It is further preferred that the at least one thermal via is arranged in a trench in the central solder pad.

It is further proposed that at least one surface mounted component is mounted on the mounting position, wherein a central solder joint is formed on the central solder pad. The central solder joint on the proposed central solder pad has a low void content and provides a high reliability.

In a preferred embodiment, the surface mounted component is a quad flat pack (QFN) or a small outline integrated circuit (SOIC) or land grid array (LGA).

In the following the invention shall be illustrated on the basis of preferred embodiments with reference to the accompanying drawings. Therein shows:
- Fig. 1: an x-ray image of a circuit board with a bottom terminated component with a central solder joint with high void content according to the prior art;
- Fig. 2: an x-ray image of a circuit board with a bottom terminated component with a central solder joint with low void content according to the invention;
- Fig. 3: a circuit board with four through-holes and multiple thermal vias in the central solder pad;
- Fig. 4: a circuit board with four through-holes arranged in trenches and multiple thermal vias in the central solder pad;
- Fig. 5: a circuit board with three through-holes and multiple thermal vias in the central solder pad; and
- Fig. 6: a detail-view of a through-hole in the central solder pad of a circuit board.

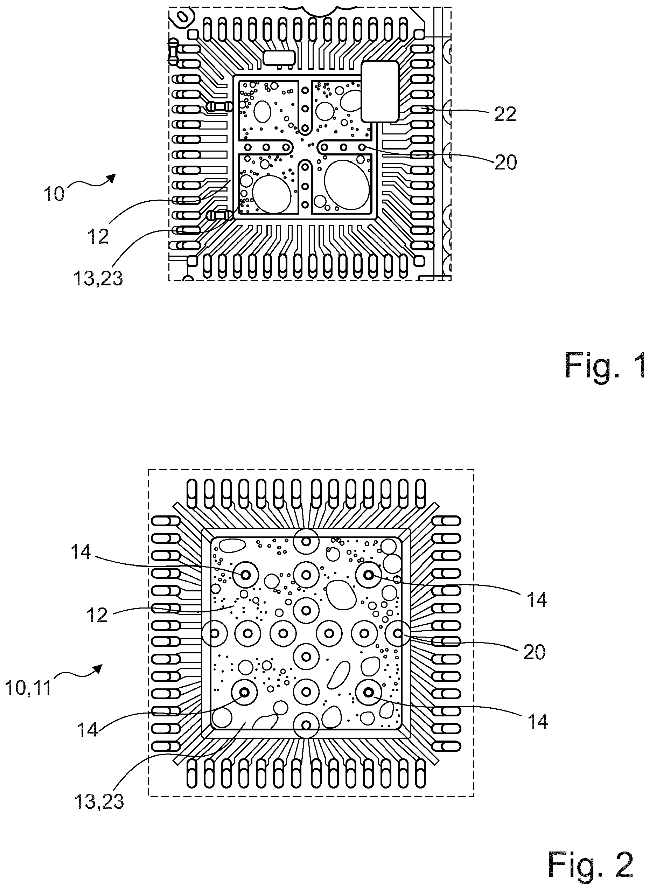

Figure 1 shows a circuit board 10 according to the prior art with a mounting position 11 for a surface mounted component (SMC) 12, wherein the surface mounted component 12 is a bottom terminated component (BTC) that is soldered to the mounting position 11. The mounting position 11 comprises a central solder pad 13 which is also known as thermal pad. The formed central solder joint 23 on the central solder pad 13 provides a thermal and mechanical connection between the surface mounted component 12 and the circuit board 10. The central solder joint 23 in the prior art has a high content of voids 21 due to trapped gas during curing or the soldering process as shown in Figure 1. The high void content reduces the reliability and thermal properties of the formed central solder joint 23 in the prior art.

Figure 2 shows an embodiment of a circuit board 10 having a mounting position 11 for surface mounted component 12, in particular a bottom terminated component, soldered to the mounting position 11 according to the invention. Four through-holes 14 are arranged in the central solder pad 13 which have a non-conductive surface 15. The through-holes 14 are preferably unplated. The four through-holes 14 enable sufficient venting of gas during the soldering process to reduce the void content in the central solder joint 23 between the surface mounted component 12, in particular the bottom terminated component, and the mounting position 11 of the circuit board 10. This reduces the void content in the central solder joint 23 in comparison to the prior art illustrated in Figure 1.

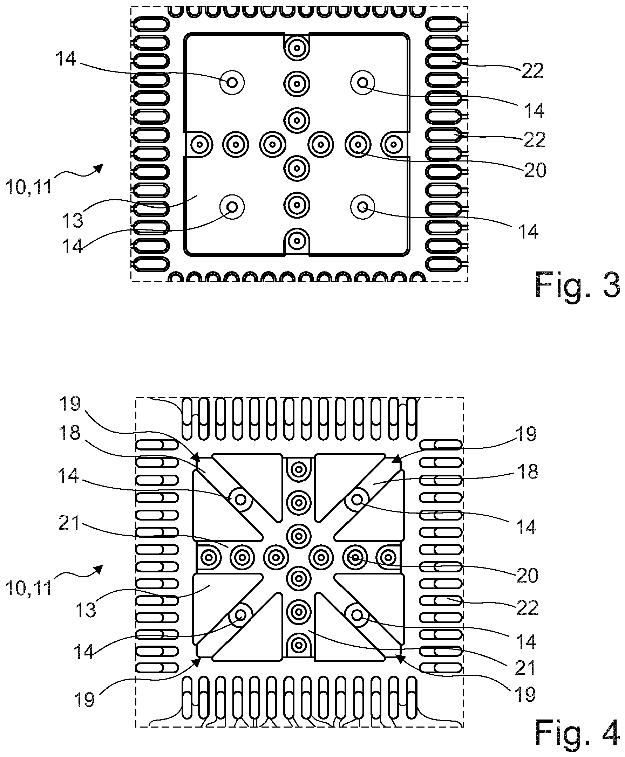

Figure 3, 4 and 5 show different embodiments of circuit boards 10 with a mounting position 11 for a surface mounted component 12. The mounting position 11 comprises a central solder pad 13, also known as thermal pad, wherein multiple solder contacts 22 for the input/output leads of the surface mounted component 12 are arranged along the edges of the central solder pad 13.

The embodiment of Figure 3 shows four through-holes 14 arranged in a rectangular shape in the central solder pad 13. Further on, the central solder pad 13 comprises nine thermal vias 20 that are arranged in a cross-shape. These thermal vias 20 may extend as a hole through the circuit board 10, but have a conductive surface with respect to electricity and provide good heat transfer capability so that the surface is wetted with solder during the soldering process and solder is wicked down to the bottom of the circuit board 10.

In Figure 4 another embodiment of a circuit board 10 is shown, wherein the through-holes 14 and the thermal vias 20 are arranged similar to the embodiment of Figure 3. The embodiment of Figure 4 comprises two trenches 18 in the central solder pad 13 that extent from corner 19 to corner 19 in a diagonal way and cross each other at the center of the central solder pad 13. Further on, thermal vias 20 are also arranged in two trenches 21 extending parallel to the edges of the central solder pad 13 and crossing each other at the center of the central solder pad 13.

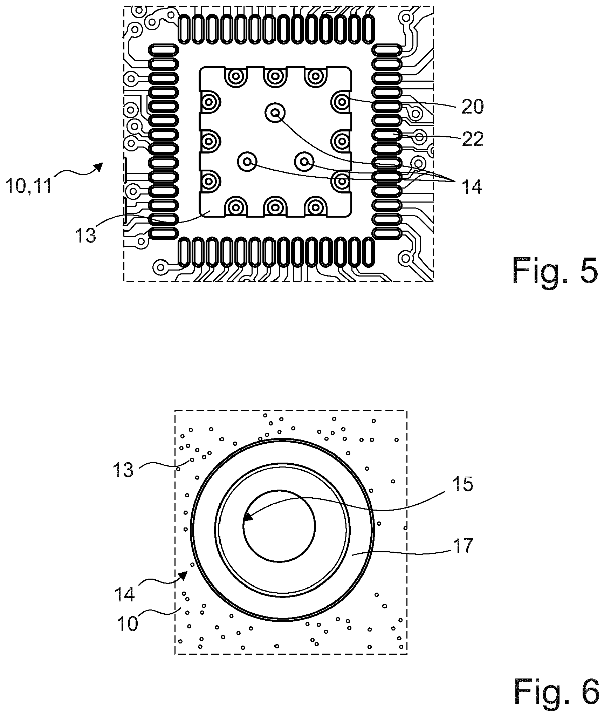

In Figure 5 another embodiment is shown, wherein three through-holes 14 with non-conductive surfaces 15 are arranged in a triangular shape in the middle of the central solder pad 13. Multiple thermal vias 20 are arranged along the edges of the central solder pad 13.

Figure 6 shows a detail-view of a through-hole 14 with non-conductive surface 15 in central solder pad 13 of a mounting position 11. The opening of the through-hole 14 is surrounded by a cutout 17 in the copper layer of the central solder pad 13, so that solder wetting is inhibited next to the opening of the through-hole.

## Claims

1. Circuit board (10) with at least one mounting position (11) for a surface mounted component (12), wherein the surface mounted component (12) is a bottom terminated component, wherein the mounting position (11) comprises a central solder pad (13), **characterized in that** the circuit board (10) comprises at least one through-hole (14) in the central solder pad (13), wherein the surface (15) of the at least one through-hole (14) is non-conductive.

2. Circuit board (10) according to claim 1, **characterized in that** the surface (15) of the at least one through-hole (14) is glass fiber-reinforced plastic.

3. Circuit board (10) according to claims 1 or 2, **characterized in that** the at least one through-hole (14) is unplated.

4. Circuit board (10) according to any one of the preceding claims, **characterized in that** the central solder pad (13) has a cutout (17) in the copper layer around the at least one through-hole (14).

5. Circuit board (10) according to any one of the preceding claims, **characterized in that** the at least one through-hole (14) is arranged in a trench (18) in the central solder pad (13).

6. Circuit board (10) according to claim 5, **characterized in that** the trench (18) is arranged in a diagonal of the central solder pad (13).

7. Circuit board (10) according to claim 5 or 6, **characterized in that** the trench (18) extends into a corner (19) of the central solder pad (13).

8. Circuit board (10) according to any one of the preceding claims, **characterized in that** four through-holes (14) are arranged in a rectangular shape in the central solder pad (13) .

9. Circuit board (10) according to claim 8, **characterized in that** three through-holes (14) are arranged in a triangular shape in the central solder pad (13).

10. Circuit board (10) according to any one of the preceding claims, **characterized in that** the circuit board (10) comprises at least one thermal vias (20) besides the at least one through-hole (14).

11. Circuit board (10) according to claim 10, **characterized in that** the at least one thermal via (20) is arranged in a trench (21) in the central solder pad (13).

12. Circuit board (10) according to any one of the preceding claims, **characterized in that** at least one surface mounted component (12) is mounted on the mounting position (11), wherein a central solder joint (23) is formed on the central solder pad (13).
